# FASCICULE DE BREVET EUROPEEN

(11) **EP 4 432 543 B1**
(45) Date de publication et mention de la délivrance du brevet: **26.11.2025**
(21) Numéro de dépôt: 24192477.8
(22) Date de dépôt: 23.10.2017
(51) Int. Cl.: H02M 7/00

(54) **CONVERTISSEUR DE TENSION DESTINÉ À ALIMENTER EN PUISSANCE UNE MACHINE ÉLECTRIQUE POUR VÉHICULE AUTOMOBILE**
SPANNUNGSWANDLER ZUR LEISTUNGSVERSORGUNG EINER ELEKTRISCHEN MASCHINE FÜR KRAFTFAHRZEUGE
VOLTAGE CONVERTER FOR SUPPLYING POWER TO AN ELECTRIC MACHINE FOR A MOTOR VEHICLE

(30) Priorité: 21.10.2016 FR 1660235
(43) Date de publication de la demande: 18.09.2024
(62) Demande divisionnaire de: 17197817.4
(73) Titulaire: Valeo Electrification, 95800 Cergy (FR)
(72) Inventeur: FALGUIER, Manuel, 94046 Créteil Cedex (FR); SANCHES, Michael, 94046 Créteil Cedex (FR); BAUDESSON, Philippe, 94000 Créteil (FR)
(74) Mandataire: Valeo Powertrain Systems

(56) Documents cités:
- JP-A- 2002 084 790
- US-A1- 2008 049 477
- US-A1- 2014 345 492
- US-A1- 2015 313 040
- US-B2- 6 956 742
- MARTY BROWN: "Considerations in Designing the Printed Circuit Boards of Embedded Switching Power Supplies", INTERNET CITATION, 30 August 2000 (2000-08-30), pages 1 - 8, XP002512584, Retrieved from the Internet <URL:http://web.archive.org/web/20000831125718/http://www.fairchildsemi.com/an/AN/AN-1031.pdf> [retrieved on 20080127]

## Description

L'invention concerne un convertisseur de tension, notamment destiné à alimenter en puissance une machine électrique pour véhicule automobile.

L'invention concerne également un équipement électrique comprenant une machine électrique et un tel convertisseur de tension.

En général, un moteur électrique, notamment pour véhicule automobile, comprend un convertisseur de tension, supporté par un châssis, comprenant des unités électroniques de puissance contrôlées par une unité électronique de contrôle.

Le convertisseur de tension peut également comprendre un bloc de condensateurs configuré pour stabiliser une tension électrique reçue par les unités électroniques de puissance et pour réduire les perturbations électromagnétiques générées par les unités électroniques de puissance et de contrôle.

En général, le bloc de condensateurs est intégré au sein du convertisseur de tension à distance des unités électroniques de puissance, les condensateurs du bloc de condensateurs étant volumineux.

Cependant, la distance entre le bloc de condensateurs et les unités électroniques de puissance induit la présence d'une capacité parasite au sein du convertisseur de tension.

Afin de réduire, voire supprimer cette capacité parasite, il existe des convertisseurs de tension dans lesquels les unités électroniques de puissance comprennent des condensateurs en céramique, intégrés directement au sein des unités électroniques de puissance, de sorte à filtrer la tension d'entrée des unités électroniques de puissance. Cependant, cette solution technique est couteuse et entraine une modification du procédé d'assemblage des unités électroniques de puissance, notamment par l'ajout d'une étape de collage des condensateurs en céramique sur les unités électroniques de puissance.

Il existe également des convertisseurs de tension comprenant un connecteur électrique configuré pour connecter électriquement les condensateurs du bloc de condensateurs aux unités électroniques de puissance. Cependant, cette solution technique est couteuse et volumineuse. En effet, comme les condensateurs et les unités électroniques de puissance ne présentent pas les mêmes dimensions, le connecteur électrique présente un design particulier qui est difficile à intégrer au sein du convertisseur de tension.

Le document US 6 956 742 B2 concerne les configurations de convertisseurs de puissance incluant des dissipateurs thermiques qui réduisent l'espace global requis pour accueillir les configurations.

Le document US 2008/049477 A1 concerne les convertisseurs de puissance et en particulier un convertisseur de puissance utilisé pour commander un moteur pour un véhicule hybride.

Le document US 2015/313040 A1 concerne un convertisseur de puissance qui convertit la puissance d'entrée en un type de puissance spécifique et délivre la puissance résultant de la conversion.

Le document US 2014/345492 A1 concerne les équipements de contrôle de conduite d'un véhicule ferroviaire.

Le document MARTY BROWN: "Considerations in Designing the Printed Circuit Boards of Embedded Switching Power Supplies", INTERNET CITATION, 30 août 2000 (2000-08-30), pages 1-8, XP002512584, divulgue concerne la conception des circuits imprimés des alimentations à découpage embarquées.

Le document JP 2002 084790 A concerne le dispositif de commande d'une machine électrique rotative (moteur-générateur) utilisée dans un véhicule électrique (véhicule hybride), en particulier le dispositif de commande de la machine électrique rotative permettant de réduire le courant d'ondulation.

La présente invention vise à remédier à ces inconvénients en proposant un convertisseur de tension permettant de minimiser la distance entre le bloc de condensateurs et les unités électroniques de puissance, et par conséquent de réduire les perturbations électromagnétiques au sein du convertisseur de tension, sans en augmenter le coût et l'encombrement.

L'invention est définie par un convertisseur de tension, tel que défini dans la revendication
1. D'autres modes de réalisation préférés sont définis dans les revendications dépendantes.

A cet effet, l'invention a pour objet un convertisseur de tension, notamment destiné à alimenter en puissance une machine électrique pour véhicule automobile, comprenant :
- au moins deux unités électroniques de puissance configurées pour convertir une tension électrique, chaque unité électronique de puissance comprenant deux bras de commutation,
- un bloc de filtrage configuré pour filtrer la tension électrique d'entrée de l'unité électronique de puissance,
les au moins deux unités électroniques de puissance et le bloc de filtrage étant connectés électriquement via chaque bras de commutation desdites unités électroniques de puissance, et
dans lequel les distances entre chaque bras de commutation et le bloc de filtrage sont sensiblement identiques.

Avantageusement, la configuration du convertisseur de tension selon l'invention, et notamment une distance sensiblement identique entre les unités électroniques de puissance et le bloc de filtrage, permet de réduire les perturbations électromagnétiques parasites émises par les unités électroniques de puissance au sein du convertisseur de tension, et par conséquent d'optimiser la compatibilité électromagnétique entre le convertisseur de tension et la machine électrique.

Le convertisseur de tension peut également comprendre une ou plusieurs des caractéristiques suivantes, considérées individuellement ou selon toutes les combinaisons possibles :
- le bloc de filtrage comprenant au moins deux unités de filtrage, la distance minimale entre les bras de commutation d'une unité électronique de puissance et une unité de filtrage est sensiblement identique à la distance minimale entre les bras de commutation de l'autre unité électronique de puissance et l'autre unité de filtrage ; et/ou
- le bloc de filtrage comprenant au moins deux unités de filtrage, la distance minimale entre les bras de commutation d'une unité électronique de puissance et l'unité de filtrage à laquelle lesdits bras sont connectés est sensiblement identique à la distance minimale entre les bras de commutation de l'autre unité électronique de puissance et l'unité de filtrage à laquelle les bras de commutation de l'autre unité électronique de puissance sont connectés ; et/ou
- le bloc de filtrage comprenant au moins deux unités de filtrage, les distances minimales entre chaque bras de commutation des unités électroniques de puissance et l'unité de filtrage à laquelle chacun des dits bras de commutation est connecté sont sensiblement identiques ; et/ou
- la distance minimale entre chaque bras de commutation de chaque unité électronique de puissance et une unité de filtrage est inférieure à 10 mm ; et/ou
- la distance minimale entre chaque bras de commutation de chaque unité électronique de puissance et l'unité de filtrage à laquelle chaque bras de commutation est connecté est inférieure à 10 mm ; et/ou
- le convertisseur de tension comprend également un connecteur électrique configuré pour connecter électriquement le bloc de filtrage à chaque bras de commutation de chaque unité électronique de puissance ; et/ou
- les au moins deux unités électroniques de puissance sont agencées l'une à côté de l'autre, et dans lequel le bloc de filtrage s'étend longitudinalement le long de la direction d'agencement des unités électroniques de puissance de sorte que les distances entre chaque bras de commutation et le bloc de filtrage sont sensiblement identiques ; et/ou
- le convertisseur de tension comprend au moins trois unités électroniques de puissance, et dans lequel les au moins trois unités électroniques de puissance sont alignées les unes à côté des autres, et dans lequel le bloc de filtrage s'étend sensiblement parallèlement à la direction d'alignement des unités électroniques de puissance de sorte que les distances entre chaque bras de commutation de chaque unité électronique de puissance et le bloc de filtrage sont sensiblement identiques ; et/ou
- le bloc de filtrage comprenant au moins une unité de filtrage, telle que les au moins deux unités électroniques de puissance sont séparées par la au moins une unité de filtrage de sorte que les distances minimales entre chaque bras de commutation et l'unité de filtrage sont sensiblement identiques ; et/ou
- le bloc de filtrage comprenant au moins une unité de filtrage, telle que les au moins deux unités électroniques de puissance sont séparées par la au moins une unité de filtrage de sorte que les distances minimales entre chaque bras de commutation et l'unité de filtrage à laquelle chaque bras de commutation est connecté sont sensiblement identiques ; et/ou
- le convertisseur de tension comprend au moins trois unités électroniques de puissance, le bloc de filtrage comprenant au moins trois unités de filtrage, une unité électronique de puissance étant séparée d'une autre unité électronique de puissance par une unité de filtrage de sorte que les distances minimales entre chaque bras de commutation de chaque unité électronique de puissance et une unité de filtrage sont sensiblement identiques ; et/ou
- le convertisseur de tension comprend au moins trois unités électroniques de puissance, le bloc de filtrage comprenant au moins trois unités de filtrage, une unité électronique de puissance étant séparée d'une autre unité électronique de puissance par une unité de filtrage de sorte que les distances minimales entre chaque bras de commutation de chaque unité électronique de puissance et l'unité de filtrage à laquelle chaque bras de commutation est connecté sont sensiblement identiques ; et/ou
- les unités électroniques de puissance sont régulièrement réparties le long d'une courbe fermée, une unité de filtrage étant disposée entre deux unités électroniques de puissance successives ; et/ou
- le convertisseur de tension comprend également un dissipateur thermique comprenant un support de réception des au moins deux unités électroniques de puissance et du bloc de filtrage, le support de réception comprend au moins une cavité de réception du bloc de filtrage et une zone de réception respective de chaque unité électronique de puissance ; et/ou
- le dissipateur thermique comprend également un couvercle et un joint métallique, le joint métallique étant agencé entre le support de réception et le couvercle ; et/ou
- le dissipateur thermique comprend un circuit de refroidissement comportant un canal de circulation d'un fluide de refroidissement ; et/ou
- le bloc de filtrage comprenant au moins une unité de filtrage comprenant une partie inférieure sensiblement plane agencée en vis-à-vis du fond de ladite cavité de réception et une paroi latérale s'étendant depuis la partie inférieure dans une direction sensiblement perpendiculaire à ladite partie inférieure, le circuit de refroidissement comprenant une première portion s'étendant sensiblement parallèlement à la paroi latérale de la au moins une unité de filtrage, la première portion du circuit de refroidissement étant adjacente à la paroi latérale de l'unité de filtrage ; et/ou
- la première portion comprend une face externe d'une paroi latérale du canal de circulation du fluide de refroidissement ; et/ou
- le support de réception comprend un premier et un deuxième plans d'appui, le premier plan d'appui comprenant au moins une cavité de réception du bloc de filtrage et le deuxième plan d'appui comprenant au moins une zone de réception d'une unité électronique de puissance, le circuit de refroidissement comprenant une première partie s'étendant sensiblement parallèlement au premier plan d'appui et une deuxième partie s'étendant sensiblement parallèlement au deuxième plan d'appui ; et/ou
- chaque unité électronique de puissance comprenant un substrat plan comprenant une face supérieure et une face inférieure, la face inférieure de chaque unité électronique de puissance étant agencée en vis à vis de la zone de réception du dissipateur thermique, le circuit de refroidissement comprenant une deuxième portion s'étendant sensiblement parallèlement à la face inférieure de chaque unité électronique de puissance, l'unité électronique de puissance, la zone de réception et la deuxième portion du circuit de refroidissement étant superposés les uns sur les autres ; et/ou
- la deuxième portion comprend une face externe d'une paroi de fond du canal de circulation du fluide de refroidissement ; et/ou
- une unité électronique de puissance comprend un module électronique de puissance, et une unité de filtrage comprend deux condensateurs.

Avantageusement, une distance minimale entre les bras de commutation des unités électroniques de puissance et le bloc de filtrage permet de limiter la création d'une capacité parasite, et par conséquent de limiter les perturbations électromagnétiques émises au sein du convertisseur de tension.

De plus, un convertisseur de tension selon l'invention comprenant un dissipateur thermique comprenant une première portion s'étendant parallèlement à la paroi latérale d'une unité de filtrage du bloc de filtrage et une deuxième portion s'étendant parallèlement à chaque unité électronique de puissance permet un refroidissement efficace des unités électroniques de puissance et du bloc de filtrage du convertisseur de tension. En outre, un tel dissipateur thermique permet une simplification du procédé de fabrication du convertisseur de tension, sans induire une perte de charge au niveau des unités de filtrage du bloc de filtrage.

De façon avantageuse, un convertisseur de tension selon l'invention comprenant un dissipateur thermique qui comprend différents plans d'appui permet de compenser la différence de dimension entre les unités électroniques de puissance et les unités de filtrage. En effet, dans un tel convertisseur de tension les connections électriques entre les unités électroniques de puissance et les unités de filtrage sont minimisées, et par conséquent les pertes électromagnétiques susceptibles d'être générées au sein du convertisseur de tension sont limitées.

L'invention se rapporte également à un équipement électrique comprenant une machine électrique et un convertisseur de tension selon l'invention destiné à contrôler une énergie électrique échangée entre la machine électrique et un réseau électrique extérieur, et dans lequel le convertisseur de tension est monté sur la machine électrique.

D'autres caractéristiques et avantages de la présente invention apparaitront à la lecture de la description détaillée de modes de réalisation donnés à titre d'exemples non limitatifs et illustrés, accompagnée des figures suivantes :
- la figure 1 représente une vue de dessus d'un convertisseur de tension selon un mode de réalisation de l'invention,
- la figure 2 représente une vue de dessus d'un convertisseur de tension selon un exemple,
- les figures 3 et 5 représentent des vues éclatées de convertisseurs de tension selon des modes de réalisation de l'invention,
- les figures 4 et 6 représentent des vues éclatées de convertisseurs de tension selon un exemple,
- la figure 7 représente une vue éclatée d'un dissipateur thermique d'un convertisseur de tension selon un mode de réalisation de l'invention, et
- les figures 8 et 9 représentent des vues en coupe de deux convertisseurs de tension selon un mode de réalisation de l'invention.

Il est à noter que ces dessins n'ont d'autre but que d'illustrer le texte de la description et ne constituent en aucune sorte une limitation de la portée de l'invention. L'invention est définie par les revendications annexées.

Sur les différentes figures, les éléments analogues sont désignés par des références identiques.

L'invention concerne un équipement électrique, notamment pour véhicule automobile, comprenant une machine électrique et un convertisseur de tension.

En particulier, le convertisseur de tension peut être monté sur la machine électrique.

Le convertisseur de tension est destiné à contrôler une énergie électrique échangée entre la machine électrique et une source d'alimentation électrique.

Le convertisseur de tension peut être embarqué dans un véhicule automobile. Le convertisseur de tension peut être par exemple un onduleur de tension.

La source d'alimentation électrique peut être un réseau électrique extérieur, notamment un réseau électrique d'un véhicule automobile. Un réseau électrique est par exemple un réseau électrique alimenté par une tension électrique de +48V. De préférence, le réseau électrique est un réseau d'énergie électrique continue. Le réseau électrique peut comprendre une batterie alimentant ledit réseau électrique.

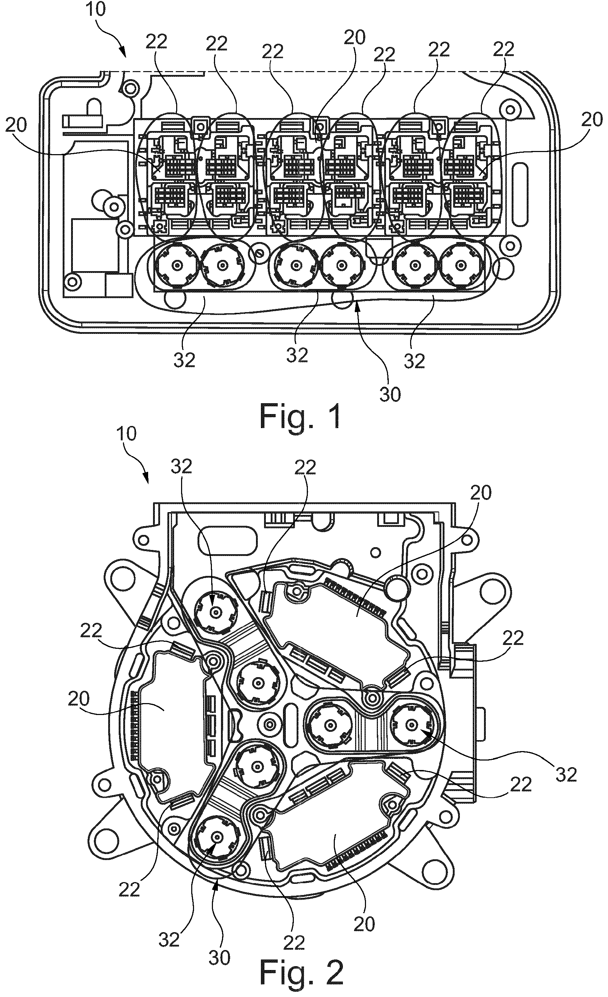

Deux exemples d'un convertisseur de tension 10 sont représentés sur les figures 1 (selon l'invention) et 2.

Le convertisseur de tension 10 est notamment destiné à alimenter en puissance une machine électrique pour véhicule automobile.

Un convertisseur de tension 10 comprend au moins deux unités électroniques de puissance 20, par exemple trois unités électroniques de puissance 20 sur les figures 1 et 2, configurées pour convertir une tension électrique. En particulier, une unité électronique de puissance peut convertir une tension alternative en une tension continue, et inversement.

Une unité électronique de puissance 20 peut être un module électronique de puissance.

Une unité électronique de puissance 20 peut comprendre un ou une pluralité de composants électroniques, par exemple une pluralité de puces électroniques semiconductrices, notamment des puces nues, montés sur un substrat plan.

En particulier, une unité électronique de puissance 20 peut comprendre une ou une pluralité de traces de puissance.

Une trace de puissance peut être connectée électriquement à la pluralité de composants électroniques.

Une trace de puissance est une trace conductrice électriquement, notamment métallique, par exemple en cuivre. Une trace de puissance peut être une lame métallique ou un barreau métallique. Une trace de puissance est destinée à transmettre un courant électrique entre la source d'alimentation électrique et la machine électrique.

Par exemple, une unité électronique de puissance 20 peut comprendre une première trace de puissance, une deuxième trace de puissance et une troisième trace de puissance. La première trace de puissance peut être reliée électriquement à un premier pôle du réseau électrique, par exemple, à un pôle de polarité positive +48V. La deuxième trace de puissance peut être reliée électriquement à un deuxième pôle du réseau électrique, par exemple, à un pôle de polarité négative -48V ou à la masse de la source d'alimentation électrique, par exemple égale à 0V. La troisième trace de puissance peut être reliée électriquement à une phase (φ) de la machine électrique. Les première, deuxième et troisième traces de puissance sont distinctes l'une de l'autre et peuvent être en partie surmoulées de matériau isolant électriquement, par exemple de matériau plastique.

Le convertisseur de tension 10 comprend un bloc de filtrage 30 configuré pour filtrer la tension électrique d'entrée de l'unité électronique de puissance 20. Un bloc de filtrage 30 peut comprendre un ou une pluralité d'éléments de filtrage, par exemple une pluralité de condensateurs.

Chaque unité électronique de puissance 20 comprend deux bras de commutation 22. Un bras de commutation 22 peut comprendre des portions de traces de puissance et des composants électroniques.

Les unités électroniques de puissance 20 et le bloc de filtrage 30 sont connectés électriquement via chaque bras de commutation 22 des unités électroniques de puissance 20.

Les distances entre chaque bras de commutation 22 des unités électroniques de puissance 20 et le bloc de filtrage 30 sont sensiblement identiques.

Par distance sensiblement identique entre chaque bras de commutation des unités électroniques de puissance et le bloc de filtrage, on entend que la distance entre les bras de commutation d'une première unité électronique de puissance et du bloc de filtrage peut être supérieure ou égale à 85% de la distance entre les bras de commutation d'une deuxième unité électronique de puissance et du bloc de filtrage et inférieure ou égale à 115% de la distance entre les bras de commutation de la deuxième unité électronique de puissance et du bloc de filtrage. Préférentiellement, la distance entre les bras de commutation de la première unité électronique de puissance et du bloc de filtrage peut être comprise entre 95% et 105% de la distance entre les bras de commutation de la deuxième unité électronique de puissance et du bloc de filtrage.

En limitant la différence entre les distances entre les bras de commutation des unités électroniques de puissance et les unités de filtrage du bloc de filtrage, les perturbations électromagnétiques susceptibles d'apparaitre lors d'une circulation de courant dans les traces de puissance des unités électroniques de puissance sont limitées.

De préférence, les distances entre chaque bras de commutation 22 des unités électroniques de puissance 20 et le bloc de filtrage 30 sont égales.

Avantageusement, une distance identique entre les unités électroniques de puissance et le bloc de filtrage permet de rendre négligeable ces perturbations électromagnétiques.

Autrement dit, une symétrie entre les distances entre les bras de commutation des unités électroniques de puissance et les unités de filtrage du bloc de filtrage permet d'optimiser la compatibilité électromagnétique entre le convertisseur de tension et la machine électrique.

Le bloc de filtrage 30 peut comprendre au moins deux unités de filtrage 32, par exemple trois unités de filtrage 32 sur les figures 1 et 2. Une unité de filtrage 32 correspond à un groupement d'éléments de filtrage, par exemple deux éléments de filtrage. Comme représenté sur les figures 1 et 2, le bloc de filtrage 30 comprend trois unités de filtrage de deux éléments de filtrage, ici des condensateurs.

La distance minimale entre les bras de commutation 22 d'une unité électronique de puissance 20 et une unité de filtrage 32 peut être sensiblement identique à la distance minimale entre les bras de commutation 22 d'une autre unité électronique de puissance 20 et d'une autre unité de filtrage 32. Par exemple, comme représenté sur les figures 1 et 2, la distance minimale entre les bras de commutation 22 d'une unité électronique de puissance 20 et une unité de filtrage 32 est identique à la distance minimale entre les bras de commutation 22 des deux autres unités électroniques de puissance 20 et des deux autres unités de filtrage 32.

La distance minimale entre chaque bras de commutation 22 de chaque unité électronique de puissance 20 et une unité de filtrage 32 peut être inférieure à 10 mm.

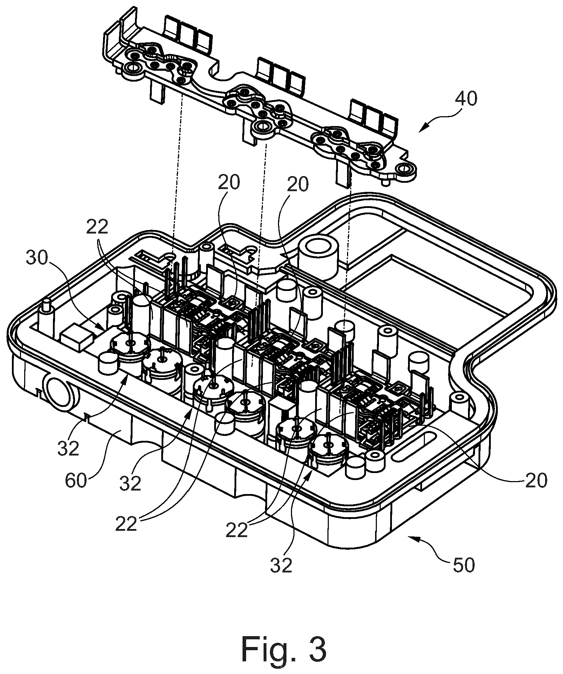

Le convertisseur de tension 10 peut également comprendre un connecteur électrique 40. Un tel convertisseur de tension 10 est par exemple représenté sur les figures 3 (selon l'invention) et 4.

Le connecteur électrique 40 est configuré pour connecter électriquement le bloc de filtrage 30 à chaque bras de commutation 22 de chaque unité électronique de puissance 20.

Le connecteur électrique 40 peut comprendre des traces de puissance. Par exemple, le connecteur électrique 40 peut comprendre une première trace de puissance, par exemple reliée électriquement à un pôle de polarité positive +48V, une deuxième trace de puissance, par exemple reliée électriquement à un pôle de polarité négative -48V ou à la masse de la source d'alimentation électrique, par exemple égale à 0V, et une troisième trace de puissance, par exemple reliée électriquement à une phase (φ) de la machine électrique. Les première, deuxième et troisième traces de puissance sont distinctes l'une de l'autre et peuvent être en partie surmoulées de matériau isolant électriquement, par exemple de matériau plastique.

Comme représenté sur les figures 1 et 3, le convertisseur de tension 10 comprend trois unités électroniques de puissance 20 agencées les unes à côté des autres. Autrement dit, les trois unités électroniques de puissance 20 sont alignées les unes à côté des autres.

Le bloc de filtrage 30 s'étend longitudinalement le long de la direction d'agencement des unités électroniques de puissance 20.

Les distances entre chaque bras de commutation 22 de chaque unité électronique de puissance 20 et le bloc de filtrage 30 peuvent être sensiblement identiques.

Autrement dit, le bloc de filtrage 30 s'étend sensiblement parallèlement à la direction d'alignement des unités électroniques de puissance 20 de sorte que les distances entre chaque bras de commutation 22 de chaque unité électronique de puissance 20 et le bloc de filtrage 30 sont sensiblement identiques.

Plus précisément, comme représenté sur la figure 3, la distance entre les bras de commutation 22 d'une unité électronique de puissance 20 et une unité de filtrage 32 du bloc de filtrage 30 est égale à la distance entre les bras de commutation 22 d'une autre unité électronique de puissance 20 et d'une autre unité de filtrage 32 du bloc de filtrage 30.

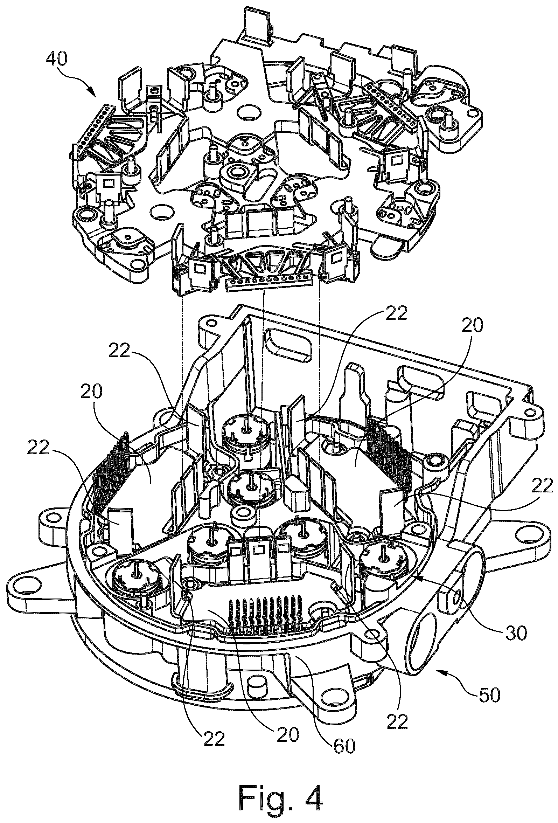

Comme représenté sur les figures 2 et 4, le bloc de filtrage 30 comprend au moins une unité de filtrage 32 agencée telle que les unités électroniques de puissance 20 sont séparées par l'une unité de filtrage 32. Les distances minimales entre chaque bras de commutation 22 et l'unité de filtrage 32 peuvent être sensiblement identiques.

Le convertisseur de tension 10 peut comprendre au moins trois unités électroniques de puissance 20 et le bloc de filtrage 30 peut comprendre au moins trois unités de filtrage 32.

Une unité électronique de puissance 20 peut être séparée d'une autre unité électronique de puissance 20 par une unité de filtrage 32 de sorte que les distances minimales entre chaque bras de commutation 22 de chaque unité électronique de puissance 20 et une unité de filtrage 32 sont sensiblement identiques.

En particulier, les unités électroniques de puissance 20 peuvent être régulièrement réparties le long d'une courbe fermée, et une unité de filtrage 32 peut être disposée entre deux unités électroniques de puissance 20 successives.

Autrement dit, le bloc de filtrage présente une forme en étoile, notamment en étoile à trois branches. Une branche du bloc de filtrage comprend une unité de filtrage. Les branches de la forme en étoile s'étendent radialement depuis un point central du bloc de filtrage et sont régulièrement espacées. Chaque unité électronique de puissance est agencée entre deux branches de la forme en étoile du bloc de filtrage, de sorte qu'une branche de la forme en étoile sépare deux unités électroniques de puissance.

Le convertisseur de tension 10 peut également comprendre un dissipateur thermique 50, notamment visible sur les figures 3 et 4.

Le dissipateur thermique 50 peut comprendre un support de réception 60 des unités électroniques de puissance 20 et du bloc de filtrage 30.

Le support de réception 60 peut comprendre une cavité de réception du bloc de filtrage 30 et une zone de réception des unités électroniques de puissance 20.

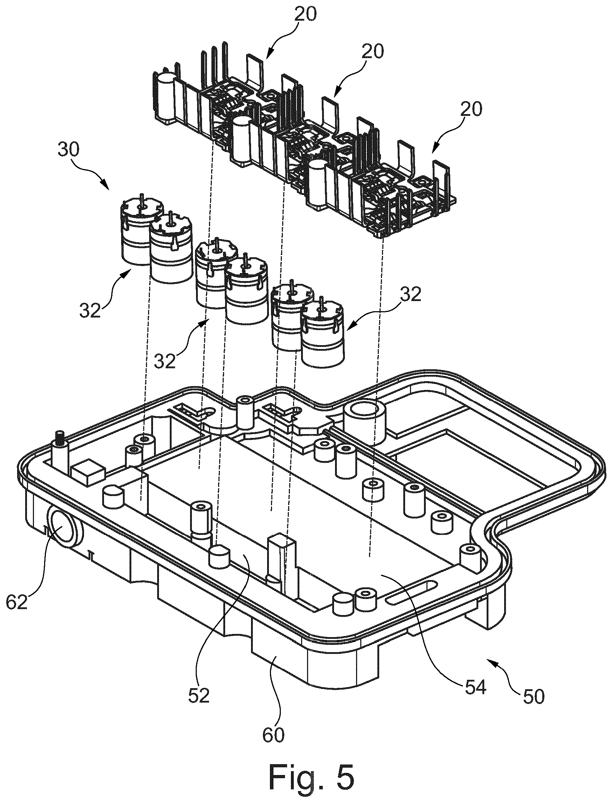

Par exemple, sur la figure 5, le support de réception 60 comprend une cavité 52 de réception des trois unités de filtrage 32 du bloc de filtrage 30 et une zone de réception 54 des unités électroniques de puissance 20.

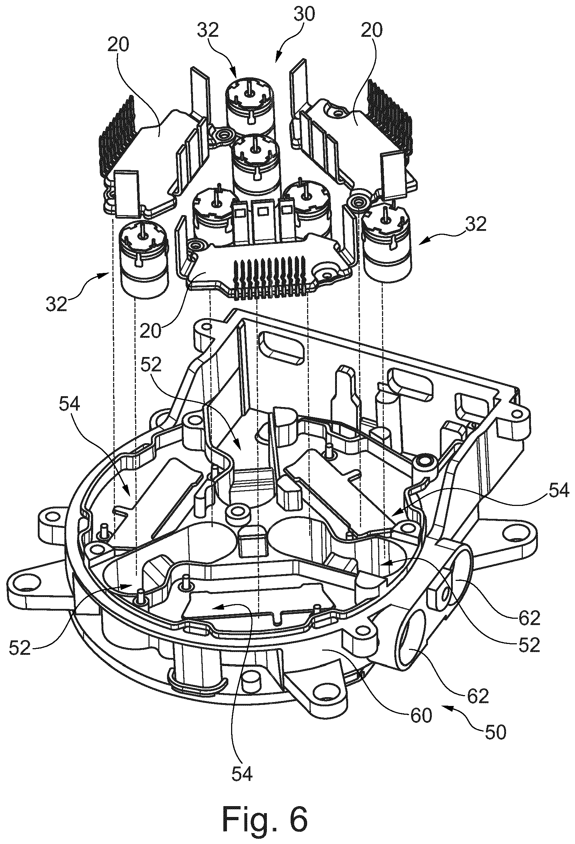

Sur la figure 6, le support de réception 60 comprend trois cavités de réception 52 du bloc de filtrage 30, chaque cavité de réception 52 recevant une unité de filtrage 32, et trois zones de réception 54 des unités électroniques de puissance 20, chaque zone de réception 54 recevant une unité électronique de puissance 20.

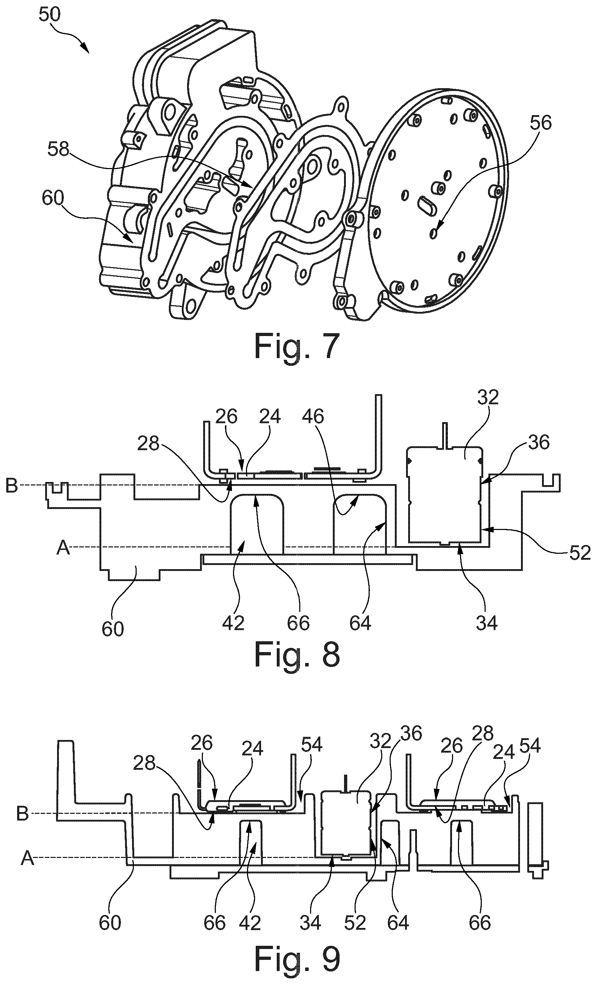

Le dissipateur thermique 50 peut également comprendre un couvercle 56 et un joint métallique 58, notamment représentés en figure 7. Autrement dit, le dissipateur thermique 50 peut être réalisé en trois parties.

De préférence, le dissipateur thermique est réalisé en matériau conducteur électriquement, par exemple en aluminium. Le support de réception 60 et le couvercle 56 peuvent être réalisés par injection sous pression, et assemblés à l'aide du joint métallique 58. Plus précisément, le joint métallique 58 peut être agencé entre le support de réception 60 et le couvercle 56.

Avantageusement, un tel dissipateur thermique présente des parois fines, ce qui permet de diminuer le poids et l'encombrement général du convertisseur de tension et d'améliorer les échanges thermiques entres les unités électroniques de puissance et le dissipateur thermique.

En outre, un tel dissipateur thermique permet une réduction des coûts de production du convertisseur de tension, notamment grâce à une réduction du coût des matériaux et l'utilisation de procédé de fabrication moins coûteux, par exemple des procédés de fabrication ne nécessitant pas d'une étape supplémentaire d'usinage.

Le dissipateur thermique 50 peut comprendre un circuit de refroidissement 62 comportant un canal de circulation d'un fluide de refroidissement. Par exemple, des ports d'entrée et de sortie du circuit de refroidissement 62 sont représentés sur les figures 5 et 6.

Un tel circuit de refroidissement permet d'avoir un débit de fluide, notamment d'eau, de 14 litres par minutes, avec une perte de charge inférieure à 80mbar. Un tel circuit de refroidissement permet d'assurer un débit permanent dans le convertisseur de tension.

Avantageusement, le dissipateur thermique comprenant un circuit de refroidissement permet un refroidissement efficace des unités électroniques de puissance et du bloc de filtrage au sein du convertisseur de tension.

Comme représenté sur les figures 8 et 9, une unité de filtrage 32 du bloc de filtrage peut comprendre une partie inférieure 34 sensiblement plane agencée en vis-à-vis du fond de la cavité de réception 52 du support de réception 60. En particulier, un matériau isolant électriquement, par exemple de la colle thermique, peut être présent entre l'unité de filtrage 32 et le fond de la cavité de réception 52 du support de réception 60. Autrement dit, la partie inférieure 34 de l'unité de filtrage 32 peut être en contact avec un matériau isolant électriquement déposé sur le fond de la cavité de réception 52 du support de réception 60.

Une unité de filtrage 32 peut également comprendre une paroi latérale 36 s'étendant depuis la partie inférieure 34 dans une direction sensiblement perpendiculaire à ladite partie inférieure 34.

Autrement dit, une unité de filtrage 32 peut avoir une forme sensiblement cylindrique comprenant deux bases reliées par une paroi latérale.

Le circuit de refroidissement peut comprendre une première portion 64 s'étendant sensiblement parallèlement à la paroi latérale 36 de l'une unité de filtrage 32. La première portion 64 du circuit de refroidissement 62 peut comprendre une face externe d'une paroi latérale du canal de circulation du fluide de refroidissement.

De préférence, la première portion 64 du circuit de refroidissement 62 est adjacente à la paroi latérale 36 de l'unité de filtrage 32. En particulier, le circuit de refroidissement 62 est agencé de sorte à refroidir la paroi latérale 36 de l'unité de filtrage 32.

Avantageusement, le circuit de refroidissement agencé de sorte à refroidir les parois latérales des unités de filtrage, plutôt que les parties inférieures des unités de filtrage, permet de simplifier le procédé de fabrication du convertisseur de tension, sans induire une perte de charge au niveau des unités de filtrage.

Comme représenté sur les figures 8 et 9, une unité électronique de puissance 20 peut comprendre un substrat plan 24 comprenant une face supérieure 26 et une face inférieure 28. De préférence, la face inférieure 28 de chaque unité électronique de puissance 20 peut être agencée en vis-à-vis de la zone de réception 54 du dissipateur thermique 50. En particulier, un matériau isolant électriquement, par exemple de la colle thermique, peut être présent entre chaque unité électronique de puissance 20 et la zone de réception 54 du dissipateur thermique 50. Autrement dit, la face inférieure 28 de chaque unité électronique de puissance 20 peut être en contact avec un matériau isolant électriquement déposé sur la zone de réception 54 du dissipateur thermique 50.

Le circuit de refroidissement peut comprendre une deuxième portion 66 s'étendant sensiblement parallèlement à la face inférieure 28 de chaque unité électronique de puissance 20. La deuxième portion 66 du circuit de refroidissement peut comprendre une face externe d'une paroi de fond du canal de circulation du fluide de refroidissement. Le circuit de refroidissement est agencé de sorte à refroidir la face inférieure 28 de chaque unité électronique de puissance 20.
En particulier, l'unité électronique de puissance 20, la zone de réception 54 et la deuxième portion 66 du circuit de refroidissement 62 peuvent être superposés les uns sur les autres.

Le support de réception 60 peut comprendre un premier plan d'appui et un deuxième plan d'appui, respectivement notés A et B sur les figures 8 et 9.

En particulier, les premier et deuxième plans d'appui A, B du support de réception 60 s'étendent sur différentes hauteurs. Autrement dit, les premier et deuxième plans d'appui A, B s'étendent parallèlement l'un par rapport à l'autre.

Le premier plan d'appui A peut comprendre au moins une cavité de réception 52 du bloc de filtrage 30.

Le deuxième plan d'appui B peut comprendre au moins une zone de réception 54 d'une unité électronique de puissance 20.

Le circuit de refroidissement 62 peut comprendre une première partie s'étendant sensiblement parallèlement au premier plan d'appui A et une deuxième partie s'étendant sensiblement parallèlement au deuxième plan d'appui B.

Comme les unités de filtrage 32 du bloc de filtrage 30 ne présentent pas les mêmes dimensions que les unités électroniques de puissance 20, les unités électroniques de puissance 20 sont disposées sur le deuxième plan d'appui B, tandis que les unités de filtrage 32 sont disposées sur le premier plan d'appui A.

La différence de hauteur entre les premier et deuxième plans d'appui A, B permet de compenser la différence de dimensions entre les unités électroniques de puissance 20 et le bloc de filtrage.

En particulier, le convertisseur de tension comprenant un connecteur électrique, la distance entre le connecteur électrique et une unité électronique de puissance est sensiblement égale à la distance entre le connecteur électrique et une unité de filtrage.

Avantageusement, la différence de hauteur entre les plans d'appui des unités électroniques de puissance et des unités de filtrage permet de minimiser la longueur de la trace de puissance du connecteur électrique reliant électriquement une unité de filtrage à une unité électronique de puissance, et ainsi de limiter les perturbations électromagnétiques susceptibles d'être générées au sein du convertisseur de tension.

Le convertisseur de tension selon l'invention a été décrit dans le cadre d'un véhicule automobile. Bien entendu, l'invention n'est nullement limitée aux modes de réalisation décrits et illustrés, qui n'ont été donnés qu'à titre d'exemples. Au contraire, d'autres applications du convertisseur de tension conforme à l'invention sont également possibles dans sortir du cadre de l'invention, telle que définie dans les revendications annexées.

## Revendications

1. Convertisseur de tension (10), étant un onduleur de tension configuré pour recevoir une tension électrique continue de 48V, le convertisseur de tension (10) étant destiné à alimenter en puissance une machine électrique pour véhicule automobile, comprenant :
- au moins trois unités électroniques de puissance (20) configurées pour convertir une tension électrique, chaque unité électronique de puissance (20) comprenant deux bras de commutation (22),
- un bloc de filtrage (30) configuré pour filtrer une tension électrique d'entrée des au moins trois unités électronique de puissance (20), le bloc de filtrage comprenant une pluralité de condensateurs formant au moins trois unités de filtrage (32),
les au moins trois unités électroniques de puissance (20) et le bloc de filtrage (30) étant connectés électriquement via chaque bras de commutation (22) desdites unités électroniques de puissance (20), et
les au moins trois unités électroniques de puissance (20) étant agencées l'une à côté de l'autre, le bloc de filtrage (30) s'étendant selon un axe longitudinal le long de la direction d'agencement des unités électroniques de puissance (20), et tous les condensateurs du bloc de filtrage se succédant selon cet axe longitudinal, les distances entre chaque bras de commutation (22) et le bloc de filtrage (30) étant sensiblement identiques.
le convertisseur de tension comprenant également un dissipateur thermique (50) comprenant un support de réception (60) des trois unités électroniques de puissance (20) et du bloc de filtrage (30), le support de réception (60) comprend au moins une cavité de réception (52) du bloc de filtrage (30) et une zone de réception (54) respective de chaque unité électronique de puissance (20).

2. Convertisseur de tension selon la revendication 1, la cavité de réception (52) du bloc de filtrage (30) étant comprise dans un premier plan d'appui (A) du support de réception (60), et le support de réception (60) comprenant un deuxième plan d'appui (B) comprenant la zone de réception (54), les premier et deuxième plans d'appui (A, B) du support de réception (60) s'étendant sur différentes hauteurs, , le premier (A) et le deuxième (B) plan d'appui s'étendant parallèlement l'un par rapport à l'autre.

3. Convertisseur de tension selon l'une quelconque des revendications 1 ou 2, chaque unité de filtrage (32) ayant une forme sensiblement cylindrique, comprenant deux bases reliées par une paroi latérale.

4. Convertisseur de tension selon l'une quelconque des revendications 1 à 3, chaque unité électronique de puissance (20) comprenant un substrat plan (24) comprenant une face supérieure (26) et une face inférieure (28), la face inférieure (28) de chaque unité électronique de puissance (20) étant agencée en vis-à-vis de la zone de réception (54) du dissipateur thermique (50).

5. Convertisseur de tension selon l'une quelconque des revendications 1 à 4, une unité de filtrage (32) du bloc de filtrage comprenant une partie inférieure (34) sensiblement plane agencée en vis-à-vis du fond de la cavité de réception (52) du support de réception (60), un matériau isolant électriquement étant présent entre l'unité de filtrage (32) et le fond de la cavité de réception (52).

6. Convertisseur de tension selon l'une quelconque des revendications 1 à 5, le dissipateur thermique (50) comprenant un circuit de refroidissement (62) comportant un canal de circulation d'un fluide de refroidissement.

7. Convertisseur de tension selon la revendication 5 et la revendication 6, l'unité de filtrage (32) comprenant la partie inférieure (34) sensiblement plane agencée en vis-à-vis du fond de ladite cavité de réception (52) comprenant une paroi latérale (36) s'étendant depuis la partie inférieure (34) dans une direction sensiblement perpendiculaire à ladite partie inférieure (34), le circuit de refroidissement (62) comprenant une première portion (64) s'étendant sensiblement parallèlement à la paroi latérale (36) de l'unité de filtrage (32), la première portion (64) du circuit de refroidissement (62) étant adjacente à la paroi latérale (36) de l'unité de filtrage (32).

8. Convertisseur de tension selon la revendication 4 et la revendication 6, le circuit de refroidissement (62) comprenant une deuxième portion (66) s'étendant sensiblement parallèlement à la face inférieure (28) de chaque unité électronique de puissance (20), l'unité électronique de puissance (20), la zone de réception (54) et la deuxième portion (66) du circuit de refroidissement (62) étant superposés les uns sur les autres.

9. Convertisseur de tension selon l'une quelconque des revendications précédentes, chacune des unités électroniques de puissance (20) comprenant un module électronique de puissance, et chacune des unités de filtrage (32) comprenant deux condensateurs.

10. Equipement électrique pour véhicule automobile, comprenant une machine électrique et un convertisseur de tension selon l'une quelconque des revendications précédentes, le convertisseur de tension étant notamment monté sur la machine électrique.

## Patentansprüche

1. Ein Spannungswandler (10), der ein Spannungsinverter ist, der dazu konfiguriert ist, eine elektrische Gleichspannung von 48V zu empfangen, wobei der Spannungswandler dazu bestimmt ist, eine elektrische Maschine für ein Kraftfahrzeug mit Strom zu versorgen, umfassend:
- mindestens drei elektronische Leistungseinheiten (20), die dazu konfiguriert sind, eine elektrische Spannung umzuwandeln, wobei jede elektronische Leistungseinheit (20) zwei Schaltarme (22) umfasst,
- einen Filterblock (30), der dazu konfiguriert ist, eine elektrische Eingangsspannung der mindestens drei elektronischen Leistungseinheiten (20) zu filtern, wobei der Filterblock eine Vielzahl von Kondensatoren umfasst, die mindestens drei Filtereinheiten (32) bilden,
wobei die mindestens drei elektronischen Leistungseinheiten (20) und der Filterblock (30) elektrisch über jeden Schaltarm (22) der besagten elektronischen Leistungseinheiten (20) verbunden sind, und
wobei die mindestens drei elektronischen Leistungseinheiten (20) nebeneinander angeordnet sind,
wobei sich der Filterblock (30) entlang einer Längsachse in Richtung der Anordnung der elektronischen Leistungseinheiten (20) erstreckt, und alle Kondensatoren des Filterblocks nacheinander entlang dieser Längsachse angeordnet sind, wobei die Abstände zwischen jedem Schaltarm (22) und dem Filterblock (30) im Wesentlichen identisch sind,
wobei der Spannungswandler ferner einen Kühlkörper (50) umfasst, der eine Aufnahmehalterung (60) für die drei elektronischen Leistungseinheiten (20) und den Filterblock (30) umfasst, wobei die Aufnahmehalterung (60) mindestens eine Aufnahmekavität (52) für den Filterblock (30) und eine jeweilige Aufnahmezone (54) für jede elektronische Leistungseinheit (20) umfasst.

2. Spannungswandler nach Anspruch 1, wobei die Aufnahmekavität (52) des Filterblocks (30) in einer ersten Auflagefläche (A) der Aufnahmehalterung (60) enthalten ist, und die Aufnahmehalterung (60) eine zweite Auflagefläche (B) umfasst, die die Aufnahmezone (54) umfasst, wobei sich die erste und zweite Auflagefläche (A, B) der Aufnahmehalterung (60) in unterschiedlichen Höhen erstrecken, wobei die erste (A) und die zweite (B) Auflagefläche parallel zueinander verlaufen.

3. Spannungswandler nach einem der Ansprüche 1 oder 2, wobei jede Filtereinheit (32) eine im Wesentlichen zylindrische Form aufweist, umfassend zwei Basen, die durch eine Seitenwand verbunden sind.

4. Spannungswandler nach einem der Ansprüche 1 bis 3, wobei jede elektronische Leistungseinheit (20) ein planares Substrat (24) umfasst, das eine obere Fläche (26) und eine untere Fläche (28) umfasst, wobei die untere Fläche (28) jeder elektronischen Leistungseinheit (20) der Aufnahmezone (54) des Kühlkörpers (50) gegenüberliegend angeordnet ist.

5. Spannungswandler nach einem der Ansprüche 1 bis 4, wobei eine Filtereinheit (32) des Filterblocks einen im Wesentlichen planaren unteren Teil (34) umfasst, der dem Boden der Aufnahmekavität (52) der Aufnahmehalterung (60) gegenüberliegend angeordnet ist, wobei ein elektrisch isolierendes Material zwischen der Filtereinheit (32) und dem Boden der Aufnahmekavität (52) vorhanden ist.

6. Spannungswandler nach einem der Ansprüche 1 bis 5, wobei der Kühlkörper (50) einen Kühlkreislauf (62) umfasst, der einen Zirkulationskanal für ein Kühlfluid aufweist.

7. Spannungswandler nach Anspruch 5 und Anspruch 6, wobei die Filtereinheit (32) den im Wesentlichen planaren unteren Teil (34) umfasst, der dem Boden der besagten Aufnahmekavität (52) gegenüberliegend angeordnet ist, umfassend eine Seitenwand (36), die sich vom unteren Teil (34) in einer Richtung im Wesentlichen senkrecht zu dem besagten unteren Teil (34) erstreckt, wobei der Kühlkreislauf (62) einen ersten Abschnitt (64) umfasst, der sich im Wesentlichen parallel zur Seitenwand (36) der Filtereinheit (32) erstreckt, wobei der erste Abschnitt (64) des Kühlkreislaufs (62) angrenzend an die Seitenwand (36) der Filtereinheit (32) ist.

8. Spannungswandler nach Anspruch 4 und Anspruch 6, wobei der Kühlkreislauf (62) einen zweiten Abschnitt (66) umfasst, der sich im Wesentlichen parallel zur unteren Fläche (28) jeder elektronischen Leistungseinheit (20) erstreckt, wobei die elektronische Leistungseinheit (20), die Aufnahmezone (54) und der zweite Abschnitt (66) des Kühlkreislaufs (62) übereinander angeordnet sind.

9. Spannungswandler nach einem der vorhergehenden Ansprüche, wobei jede der elektronischen Leistungseinheiten (20) ein elektronisches Leistungsmodul umfasst, und jede der Filtereinheiten (32) zwei Kondensatoren umfasst.

10. Elektrische Ausrüstung für ein Kraftfahrzeug, umfassend eine elektrische Maschine und einen Spannungswandler nach einem der vorhergehenden Ansprüche, wobei der Spannungswandler insbesondere auf der elektrischen Maschine montiert ist.

## Claims

1. A voltage converter (10), being a voltage inverter configured to receive a 48V direct current electrical voltage, the voltage converter being intended to power an electric machine for a motor vehicle, comprising:
- at least three electronic power units (20) configured to convert an electrical voltage, each electronic power unit (20) comprising two switching arms (22),
- a filtering block (30) configured to filter an input electrical voltage from the at least three electronic power units (20), the filtering block comprising a plurality of capacitors forming at least three filtering units (32),
the at least three electronic power units (20) and the filtering block (30) being electrically connected via each switching arm (22) of said electronic power units (20), and
the at least three electronic power units (20) being arranged next to one another, the filtering block (30) extending along a longitudinal axis along the arrangement direction of the electronic power units (20), and all the capacitors of the filtering block succeeding one another along this longitudinal axis, the distances between each switching arm (22) and the filtering block (30) being substantially identical,
the voltage converter further comprising a heat sink (50) comprising a reception support (60) for the three electronic power units (20) and the filtering block (30), the reception support (60) comprising at least one reception cavity (52) for the filtering block (30) and a respective reception zone (54) for each electronic power unit (20).

2. The voltage converter according to claim 1, wherein the reception cavity (52) of the filtering block (30) is comprised in a first support plane (A) of the reception support (60), and the reception support (60) comprises a second support plane (B) comprising the reception zone (54), the first and second support planes (A, B) of the reception support (60) extending at different heights, the first (A) and the second (B) support planes extending parallel to one another.

3. The voltage converter according to any one of claims 1 or 2, wherein each filtering unit (32) has a substantially cylindrical shape, comprising two bases connected by a lateral wall.

4. The voltage converter according to any one of claims 1 to 3, wherein each electronic power unit (20) comprises a planar substrate (24) comprising an upper face (26) and a lower face (28), the lower face (28) of each electronic power unit (20) being arranged facing the reception zone (54) of the heat sink (50).

5. The voltage converter according to any one of claims 1 to 4, wherein a filtering unit (32) of the filtering block comprises a substantially planar lower part (34) arranged facing the bottom of the reception cavity (52) of the reception support (60), an electrically insulating material being present between the filtering unit (32) and the bottom of the reception cavity (52).

6. The voltage converter according to any one of claims 1 to 5, wherein the heat sink (50) comprises a cooling circuit (62) having a circulation channel for a cooling fluid.

7. The voltage converter according to claim 5 and claim 6, wherein the filtering unit (32) comprises the substantially planar lower part (34) arranged facing the bottom of said reception cavity (52) comprising a lateral wall (36) extending from the lower part (34) in a direction substantially perpendicular to said lower part (34), the cooling circuit (62) comprising a first portion (64) extending substantially parallel to the lateral wall (36) of the filtering unit (32), the first portion (64) of the cooling circuit (62) being adjacent to the lateral wall (36) of the filtering unit (32).

8. The voltage converter according to claim 4 and claim 6, wherein the cooling circuit (62) comprises a second portion (66) extending substantially parallel to the lower face (28) of each electronic power unit (20), the electronic power unit (20), the reception zone (54) and the second portion (66) of the cooling circuit (62) being superimposed on one another.

9. The voltage converter according to any one of the preceding claims, wherein each of the electronic power units (20) comprises an electronic power module, and each of the filtering units (32) comprises two capacitors.

10. Electrical equipment for a motor vehicle, comprising an electric machine and a voltage converter according to any one of the preceding claims, the voltage converter being notably mounted on the electric machine.
